# EUROPEAN PATENT APPLICATION

(11) **EP 4 432 812 A1**
(43) Date of publication of application: **18.09.2024**
(21) Application number: 23305349.5
(22) Date of filing: 14.03.2023
(51) Int. Cl.: H10N 97/00, C25D 11/02, C25D 11/04, H01L 23/522

(54) **METHOD OF FORMING AN INTEGRATED DEVICE WITH MULTIPLE CAPACITORS BY PATTERNING A BARRIER AFTER ANODIZATION**

(71) Applicant: Murata Manufacturing Co., Ltd., Nagaokakyo-shi, Kyoto 617-8555 (JP)
(72) Inventor: LALLEMAND, Florent, 14200 HEROUVILLE SAINT-CLAIR (FR); LE CORNEC, François, 14000 CAEN (FR); LEMENAGER, Maxime, 14000 CAEN (FR); TANAY, Florent, 14650 CARPIQUET (FR)
(74) Representative: Cabinet Beau de Loménie

(57) **Abstract**

A method of forming an integrated device comprising a first capacitor and a second capacitor, comprising:
forming a metal barrier layer (103) on a substrate (100),
forming a layer including a first anodic porous oxide region (105A) surrounded by a first anodizable metal region (106A) and a second anodic porous oxide region (105B) surrounded by a second anodizable metal region (106B),
forming a first stacked capacitive structure (110A) inside the pores of the first anodic porous oxide region,
forming a second stacked capacitive structure (110B) inside the pores of the second anodic porous oxide region,
forming a first electrical connection (124A) between the top electrode layer of the first capacitor and the first anodizable metal region,
forming a second electrical connection (124B) between the top electrode layer of the second capacitor and the second anodizable metal region,
bonding a support (200),
removing the substrate,
patterning the metal barrier layer.

## Description

### Field of the Invention

The present invention relates to the field of integration and, more particularly, to electronic products, related semiconductor products, and their methods of manufacture.

The present invention more precisely relates to electronic components comprising porous regions in which capacitors are arranged.

### Technical Background

Silicon passive integration technologies are nowadays accessible for industrial design. For example, the PICS technology developed by Murata Integrated Passive Solutions allows integrating high density capacitive components into a silicon substrate. According to this technology, tens or even hundreds of passive components can be efficiently integrated into a silicon die.

In their work entitled "Nanotubular metal-insulator-metal capacitor arrays for energy storage" (published in Natural technology, May 2009), P. Banerjee *et al.* describe a metal-insulator-metal (MIM) structure formed in a porous anodic material, such as porous anodic alumina (PAA) for example. The successive layers of metal, insulator, and then metal follow the contours of the porous material resulting in the MIM structure being embedded inside the pores of the porous material. Banerjee's PAA embedded structure however suffers from high Equivalent Series Resistance (ESR) and limited capacitance density due to the PAA thickness that can be deposited by Atomic Layer Deposition (ALD).

A structure by F. Voiron *et al.* that improves Banerjee's ESR and capacitance is described in international application publication WO 2015/063420 A1. Voiron's structure results in highly integrated capacitance that may be used in a variety of applications. In this structure the bottoms of the pores are opened and the lower metal layer of the MIM structure contacts a conductive layer that underlies the porous region, providing electrical contact and reducing ESR.

Generally, PAA embedded structures as described above result from embedding a structure (e.g., a MIM capacitive stack) inside a porous region above a substrate, such as a silicon wafer. Typically, the porous region results from anodizing a thin layer of metal, such as aluminum, deposited above the substrate. The anodization converts the aluminum layer into porous anodic alumina. Typically, the porous region is formed with any shape (as viewed from the top) and extends across the alumina layer in a direction perpendicular to the wafer surface.

There exists a need for components including multiple capacitors each having specific properties. More precisely, it is desirable to have electrically insulated adjacent capacitors arranged on a same substrate, which may have different capacitance values so that they can be used for different applications. By way of example, capacitive arrays comprising multiple different capacitors may be used to decouple various voltage domains. To achieve this, it is necessary to electrically insulate the top and bottom electrodes of adjacent capacitors.

Document WO 2015/063420 A1 discloses a solution for producing a plurality of different capacitors (at least in terms of capacitance) on a same substrate. In this document, the bottom electrodes of the capacitors can be formed above a patterned metal barrier layer, with insulation between the portions of metal barrier.

Document EP 3680931 proposes using a patterned metal barrier layer and an underlying insulating layer to obtain a lateral isolation surrounding capacitors. In this document, the substrate is conductive to bring current for the anodization.

In these two prior art solutions, prior to depositing the layer of anodizable metal, it is necessary to pattern the metal barrier layer, and to deposit an insulating material. This can be particularly complex to perform and it has an impact on the subsequent anodization step. In fact, anodization is usually performed with the anodizing potential connected to the metal barrier layer. When portions of metal barrier layer are insulated from one another, it has been observed that the anodization may be incomplete through the anodizable metal layer: there remain portions of aluminum between the metal barrier layer and the anodic porous oxide regions.

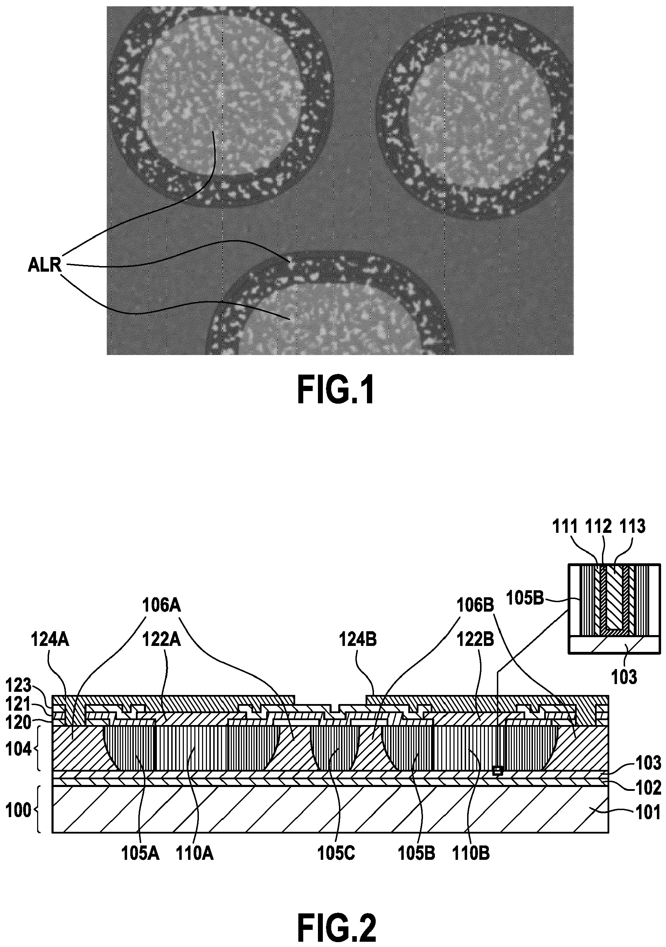

This can be observed on figure 1 that illustrates defects at the interface between a tungsten anodization barrier layer and an anodic porous oxide region (comprising alumina). On this figure, obtained by optical microscopy, the circular structures are anodic porous oxide regions formed above an electrically floating tungsten portion. These structures are speckled with aluminum residues ALR (this could lead to short circuits).

The known solutions to make, in an integrated device, arrays of capacitors, are not satisfactory. There exists a need for other solutions.

The present invention has been made in the light of the above problems.

### Summary of the Invention

The invention provides a method of forming an integrated device comprising a first capacitor and a second capacitor, comprising:
forming a metal barrier layer on a substrate,
forming, on the metal barrier layer, a layer including a first anodic porous oxide region surrounded by a first anodizable metal region and a second anodic porous oxide region surrounded by a second anodizable metal region, the first and the second anodic porous oxide regions each comprising a plurality of substantially straight pores that extend from a top surface of the anodic porous oxide region towards the metal barrier layer (i.e. through the entire thickness of the layer),
forming a first stacked capacitive structure inside the pores of the first anodic porous oxide region, the first stacked capacitive structure comprising a bottom electrode layer in electrical contact with the metal barrier layer at the bottom of the pores, a top electrode layer, and a dielectric layer arranged between the bottom and the top electrode layer, to obtain the first capacitor,
forming a second stacked capacitive structure inside the pores of the second anodic porous oxide region, the second stacked capacitive structure comprising a bottom electrode layer in electrical contact with the metal barrier layer at the bottom of the pores, a top electrode layer, and a dielectric layer arranged between the bottom and the top electrode layer, to obtain the second capacitor,
forming, above the first capacitor, a first electrical connection between the top electrode layer of the first capacitor and the first anodizable metal region,
forming, above the second capacitor, a second electrical connection between the top electrode layer of the second capacitor and the second anodizable metal region,
bonding a support above the first and the second electrical connections,
removing the substrate so as to expose the metal barrier layer,
patterning the metal barrier layer so as to electrically disconnect from each other the first anodizable metal region, the bottom electrode layer of the first capacitor, the second anodizable metal region, and the bottom electrode of the second capacitor.

Thus, during the anodization step used to form the two anodic porous oxide regions (during the forming of the layer that includes both metal portions and anodic porous oxide portions), the metal barrier layer has not yet been patterned. Consequently, the anodization can be performed without any metal residue remaining between the anodic porous oxide regions and the metal barrier layer.

This facilitates implementing the anodization step required to obtain the porous anodic oxide regions.

Also, the capacitors formed by the two stacked structures have their two electrodes not electrically connected together by the patterning of the metal barrier layer. The top electrode layer of each capacitor is electrically connected to the metal region surrounding each capacitor, which acts as a through-via through the layer that includes anodic porous oxide regions and anodizable metal. The bottom electrode layer of each capacitor is connected to the metal barrier layer at the bottom of the pores, and the patterning of the metal barrier layer allows forming an electrical contact at the level of the porous region that electrically connects to the bottom electrode.

This allows forming independent capacitors (especially if the metal regions surrounding the anodic porous oxide regions are insulated from one another), and allows keeping a full metal barrier layer during anodization (consequently, anodizable metal residues are limited).

In the above structure, electrically connecting to the capacitor electrodes is done on the backside of the structure, i.e. the side opposite to the one on which the first layers were initially forms on the substrate.

Also, as the substrate is removed, the support is used to maintain the mechanical integrity of the structure.

According to a particular embodiment, removing the substrate comprises grinding at least a portion (or the entirety) of the substrate.

According to a particular embodiment, the substrate comprises a layer of insulating material in contact with the metal barrier layer (the substrate can comprise a stack of material, typically a layer of silicon dioxide grown on a semiconductor wafer), and removing the substrate comprising grinding the substrate until the layer of insulating material is reached, and removing the layer of insulating material by etching.

According to a particular embodiment, the method comprises, patterning the metal barrier layer, forming a passivation layer including a plurality of openings that respectively open onto the first anodizable metal region, a remaining portion of anodization barrier layer under the bottom electrode layer of the first capacitor, the second anodizable metal region, and a remaining portion of anodization barrier layer under the bottom electrode of the second capacitor (i.e. there are at least four separate openings).

According to a particular embodiment, the method comprises forming a conductive contact pad inside each opening.

In this embodiment, each opening is filled with the contact pad, which is electrically in contact with the first anodizable metal region, a remaining portion of anodization barrier layer under the bottom electrode layer of the first capacitor, the second anodizable metal region, and a remaining portion of anodization barrier layer under the bottom electrode of the second capacitor.

According to a particular embodiment, the method comprises, prior to bonding the support, depositing a planarization layer above the first and the second electrical connections, and planarizing the planarization layer,
wherein the support is bonded to the planarized planarization layer.

The planarization layer can be an insulating layer configured to absorb the topology differences and configured to be planarized so as to facilitate bonding the support.

According to a particular embodiment, the support comprises an electrical component and bonding the support comprises performing a hybrid bonding.

By way of example, the electrical component of the support can be a transistor, a diode, a resistor, an inductor, or a capacitor.

In this embodiment, the two surfaces that are bonded include conductive regions (for example comprising copper) and insulating regions (for example including silicon dioxide). In a hybrid bonding, conductive regions of the two surfaces face each other so that an electrical connection is formed between the support and at least one component formed above the substrate prior to the bonding (for example the first or the second capacitor).

According to a particular embodiment, the method comprises forming a separating porous region that separates the first anodizable metal region from the second anodizable metal region.

As the anodic porous oxide region comprises an oxide of the anodizable metal barrier, it can act as an insulator between different anodizable metal regions that surround anodic porous oxide regions.

The invention also provides an integrated device comprising a first capacitor and a second capacitor, comprising:
a patterned metal layer,
on the patterned metal layer, a layer including a first anodic porous oxide region surrounded by a first anodizable metal region and a second anodic porous oxide region surrounded by a second anodizable metal region, the first and the second anodic porous oxide regions each comprising a plurality of substantially straight pores that extend from a top surface of the anodic porous oxide region towards the metal barrier layer,
a first stacked capacitive structure arranged inside the pores of the first anodic porous oxide region, the first stacked capacitive structure comprising a bottom electrode layer in electrical contact with the metal barrier layer at the bottom of the pores, a top electrode layer, and a dielectric layer arranged between the bottom and the top electrode layer, forming the first capacitor,
a second stacked capacitive structure arranged inside the pores of the second anodic porous oxide region, the second stacked capacitive structure comprising a bottom electrode layer in electrical contact with the metal barrier layer at the bottom of the pores, a top electrode layer, and a dielectric layer arranged between the bottom and the top electrode layer, forming the second capacitor,
above the first capacitor, a first electrical connection between the top electrode layer of the first capacitor and the first anodizable metal region,
above the second capacitor, a second electrical connection between the top electrode layer of the second capacitor and the second anodizable metal region,
a support bonded above the first and the second electrical connections,
wherein the metal barrier is patterned so as to electrically disconnect from each other the first surrounding region, the bottom electrode layer of the first capacitor, the second surrounding region, and the bottom electrode of the second capacitor.

This device can be obtained using any one of the above defined embodiments of the method.

According to a particular embodiment, the device comprises a passivation layer including a plurality of openings that respectively open onto the first surrounding region, a remaining portion of anodization barrier layer under the bottom electrode layer of the first capacitor, the second surrounding region, and a remaining portion of anodization barrier layer under the bottom electrode of the second capacitor.

According to a particular embodiment, the device comprises a conductive contact pad inside each opening.

According to a particular embodiment, the device comprises a planarization layer above the first and second electrical connections, having a planarized surface, the support being bonded to the planarized surface of the planarization layer.

According to a particular embodiment, the support comprises an electrical component and the support is bonded by hybrid bonding.

According to a particular embodiment, the device comprises a separating porous region that separates the first anodizable metal region from the second anodizable metal region.

### Brief Description of the Drawings

Further features and advantages of the present invention will become apparent from the following description of certain embodiments thereof, given by way of illustration only, not limitation, with reference to the accompanying drawings in which:
- Figure 1, already described, show structures according to the prior art,
- Figure 2 to 10 show the steps of the method for manufacturing a device according to an example,
- Figure 11 shows another example.

### Detailed Description of Example Embodiments

The steps for fabricating a device comprising multiple capacitors will be described hereinafter.

This embodiment addresses the existing deficiencies of the prior art relating to the complexity of forming two capacitors in porous regions and in a same device.

Figure 2 is a side view of a structure comprising a substrate 100. This structure comprising a semiconductor portion 101 (typically silicon) on which an insulating layer 102 (typically silicon dioxide) has been formed.

On the substrate and more precisely on the insulating layer, a metal barrier layer 103 has been formed. This metal barrier layer can comprise tungsten (other metals may be used, provided that they form an oxide without formation of pores under anodization conditions to stop the formation of pores). The metal barrier layer 103 is continuous, and covers the entirety of the top surface of the substrate.

On the metal barrier layer, a layer 104 has been formed. Layer 104 is obtained by first depositing a layer of anodizable metal, here aluminum, and selectively forming anodic porous oxide regions in the aluminum layer. Thus, layer 104 comprises a first anodic porous oxide region 105A surrounded by a first aluminum region 106A (when aluminum is used as the anodizable metal). On a side of the first anodic porous oxide region 105A and of the first aluminum region 106A, a second anodic porous oxide region has been formed and is surrounded by a second aluminum region 106B.

The two anodic porous oxide regions 105A and 105B are formed by anodization of the aluminum layer, this anodization being performed until the pores formed by anodization reach the metal barrier layer 103 so as to form an oxide that plugs the bottom ends of the pores. This oxide can be removed for at least a portion of the pores. Thus, the two anodic porous oxide regions each comprise a plurality of substantially straight pores that extend from a top surface of the anodic porous oxide region towards the metal barrier layer. Some pores open onto the metal barrier layer (the ones where the oxide plug has been removed).

On the figure, the two surrounding aluminum regions 106A and 106B are separated by a separating porous region 105C which is insulating as it includes anodic porous oxide.

In the first anodic porous oxide region 105A, a first stacked capacitive structure 110A has been formed. In the second anodic porous oxide region 105B, a second stacked capacitive structure 110B has been formed.

In order to show the stacked capacitive structure at the bottom of the pores of the anodic porous oxide region, the bottom of a single pore is zoomed-in in the top right corner of the figure. This shows the bottom end of pores of the first and of the second anodic porous oxide region, for a pore that opens onto the metal barrier layer 103.

The two stacked capacitive structures both include a bottom electrode layer 111 in electrical contact with the metal barrier layer 103 at the bottom of the pores (a portion of the pores if all the pores do not open onto the metal barrier layer), a top electrode layer 113, and a dielectric layer 112 arranged between the bottom and the top electrode layer, to a first capacitor in the first anodic porous oxide region and a second capacitor in the second anodic porous oxide region.

It should be noted that the two stacked structures are distinct and their constitutive layers 111, 112, and 113 are separated.

As explained above, a selective anodization has been carried out. This is performed using an anodization mask 120 that can be referred to as a hard mask. The anodization mask/hard mask can be implemented using the method disclosed in document WO 2019/202046 (possibly with another suitable material for the hard mask).

In order to select the groups of pores that accommodate the two stacked structures, a second hard mask 121 is formed with openings delimiting the capacitors. The second hard mask 121 can be analogous to the one of document EP 3567645.

The top electrode layer 113 of the two capacitors is electrically accessible from the top side of the device. A first metal contact 122A is formed above the first stacked capacitive structure, in electrical contact with the top electrode layer of this capacitor. A second metal contact 122B is formed above the second stacked capacitive structure, in electrical contact with the top electrode layer of this capacitor. A passivation layer 123 is then formed and patterned.

A first electrical connection 124A is formed between the top electrode layer of the first capacitor (through the first metal contact 122A) and the first aluminum region (through an opening in the passivation layer 123 and the two hard masks).

A second electrical connection 124B is formed between the top electrode layer of the second capacitor (through the second metal contact 122B) and the second aluminum region (through an opening in the passivation layer 123 and the two hard masks).

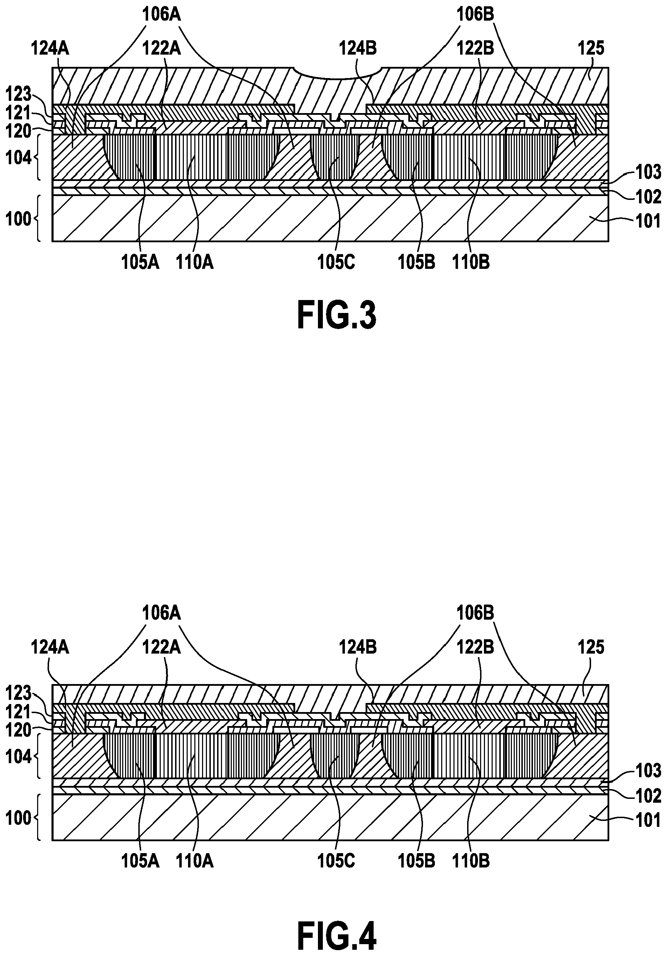

Figure 3 shows how a planarization layer 125 is formed above the structure of figure 2. The planarization layer 125 comprises silicon dioxide and can be formed using TEOS (Tetraethyl orthosilicate) as precursor to obtain a thick layer. On figure 4, layer 125 is planarized or flattened (for example through a grinding step).

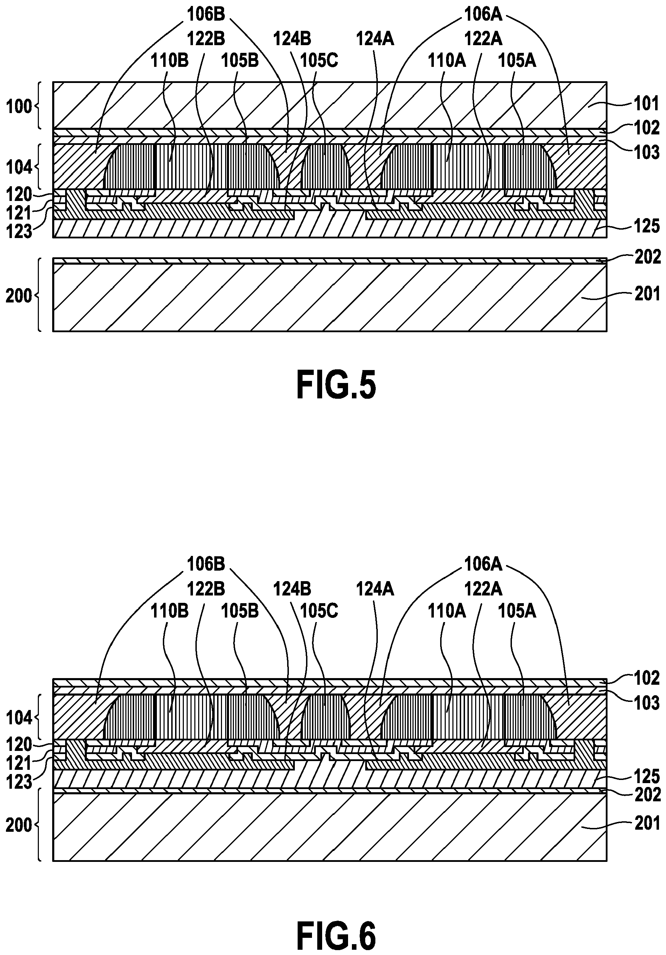

Figure 5 shows the structure obtained on figure 4 upside-down, prior to being bonded with a support 200 (preferably, the structure is turned over at this stage). Support 200 comprises a semiconductor wafer 201 on which a silicon dioxide 202 has been formed.

Figure 6 shows the structure after the bonding step has been performed, with a bonding interface between layer 125 and layer 202 bonding can be performed with the appropriate pressure and temperature. The appropriate temperature may be considered to be low by the person skilled in the art.

Figure 6 also shows that the substrate 100 has been partially removed: the semiconductor portion 101 is removed in a grinding step configured to stop when reaching the insulating layer 102.

In an alternative not represented for the sake of simplicity, removing the semiconductor portion can be performed using a technique that introduces a crack using dopants, so as to allow recycling the wafer.

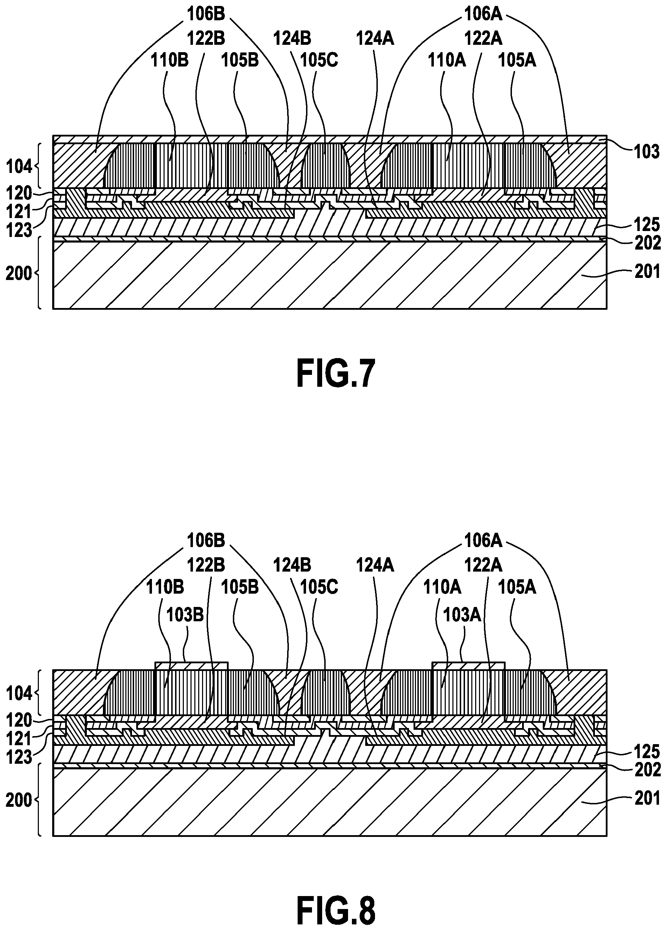

Figure 7 shows the complete removal of the substrate, as insulating layer 102 is removed by etching. Consequently, the metal barrier layer 103 is exposed.

The metal layer electrically connects together all the capacitor electrodes, for the two capacitors.

As shown on figure 8, the metal barrier layer can be patterned so as to electrically disconnect from each other the first aluminum region 106A, the bottom electrode layer of the first capacitor, the second aluminum region 106B, and the bottom electrode of the second capacitor. Here, there only remain two portions of metal barrier layer:
- A first portion 103A under the first capacitor (the structure is upside-down on the figure) and in electrical contact with the bottom electrode layer of the first stacked capacitive structure 110A,
- A second portion 103B under the second capacitor and in electrical contact with the bottom electrode layer of the second stacked capacitive structure 110B.

As a porous separating region is used, the two capacitors are fully electrically disconnected at this stage. While only two capacitors have been formed, a greater number of independent capacitors can be formed using the method described above.

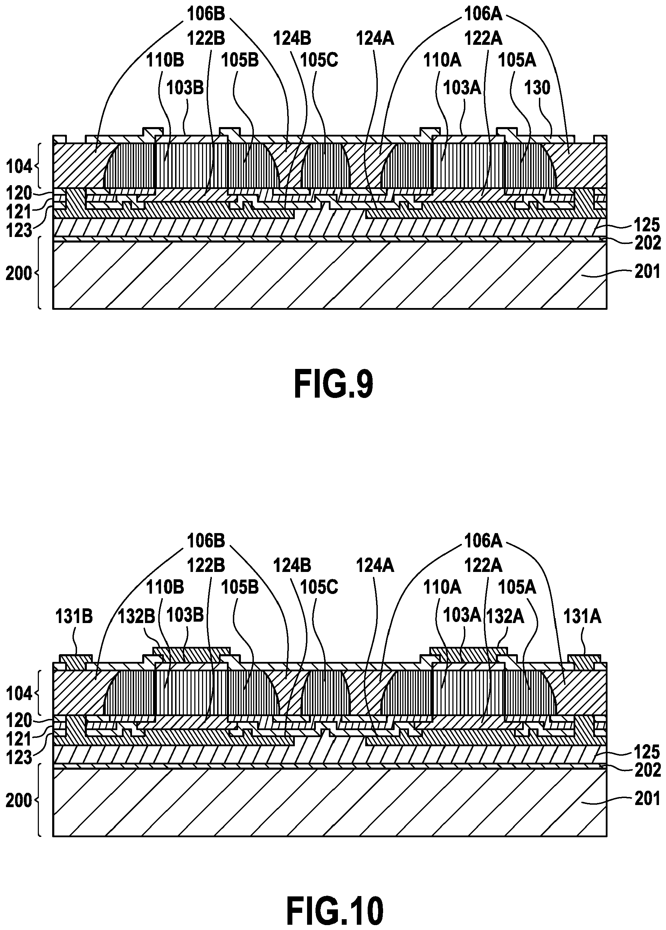

Furthermore, so as to obtain a usable device, a passivation layer 130 is formed that opens onto the first aluminum region 106A, the remaining portion 103A of anodization barrier layer under the bottom electrode layer of the first capacitor, the second aluminum region 106B, and onto the remaining portion 103B of anodization barrier layer under the bottom electrode of the second capacitor, as shown on figure 9.

Figure 10 shows the structure of figure 9 after a conductive pad has been formed in each opening:
- A conductive pad 131A for the top electrode of the first capacitor in the opening that opens onto the first aluminium region,
- A conductive pad 132A for the bottom electrode of the first capacitor in the opening that opens onto the remaining portion 103A of anodization barrier layer under the bottom electrode layer of the first capacitor,
- A conductive pad 131B for the top electrode of the second capacitor in the opening that opens onto the second aluminium region,
- A conductive pad 132B for the bottom electrode of the second capacitor in the opening that opens onto the remaining portion 103B of anodization barrier layer under the bottom electrode layer of the second capacitor.

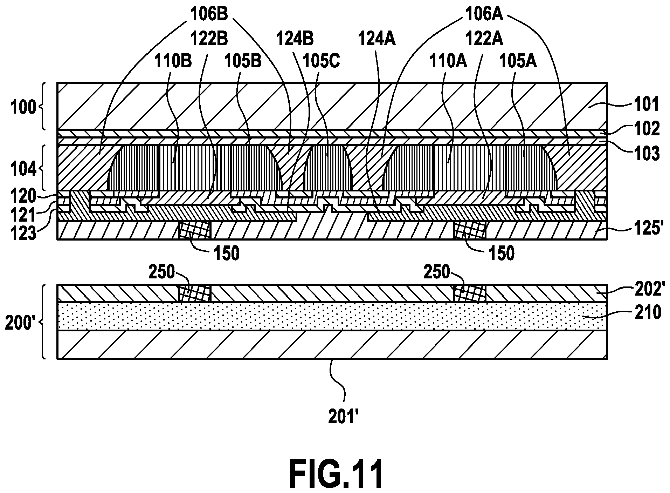

Figure 11 shows another example in which hybrid bonding is performed with a support 200'. Here, the support comprises a semiconductor portion 201' and above it a group of active and/or passive components 210.

The silicon dioxide layer 202' is patterned and accommodate copper portions 250 flush with the surface of the silicon dioxide layer 202'.

Here, the structure that includes the capacitor comprises a planarization layer 125' and has been patterned to include copper portions 150 flush with the surface of the planarization layer 125'. The copper portions face each-other so that a hybrid bonding can be performed.

### Additional Variants

Although the present invention has been described above with reference to certain specific embodiments, it will be understood that the invention is not limited by the particularities of the specific embodiments. Numerous variations, modifications and developments may be made in the above-described embodiments within the scope of the appended claims.

## Claims

1. A method of forming an integrated device comprising a first capacitor and a second capacitor, comprising:
forming a metal barrier layer (103) on a substrate (100),
forming, on the metal barrier layer, a layer including a first anodic porous oxide region (105A) surrounded by a first anodizable metal region (106A) and a second anodic porous oxide region (105B) surrounded by a second anodizable metal region (106B), the first and the second anodic porous oxide regions each comprising a plurality of substantially straight pores that extend from a top surface of the anodic porous oxide region towards the metal barrier layer,
forming a first stacked capacitive structure (110A) inside the pores of the first anodic porous oxide region, the first stacked capacitive structure comprising a bottom electrode layer (111) in electrical contact with the metal barrier layer at the bottom of the pores, a top electrode layer (113), and a dielectric layer (112) arranged between the bottom and the top electrode layer, to obtain the first capacitor,
forming a second stacked capacitive structure (110B) inside the pores of the second anodic porous oxide region, the second stacked capacitive structure comprising a bottom electrode layer (111) in electrical contact with the metal barrier layer at the bottom of the pores, a top electrode layer (113), and a dielectric layer (112) arranged between the bottom and the top electrode layer, to obtain the second capacitor,
forming, above the first capacitor, a first electrical connection (124A) between the top electrode layer of the first capacitor and the first anodizable metal region,
forming, above the second capacitor, a second electrical connection (124B) between the top electrode layer of the second capacitor and the second anodizable metal region,
bonding a support (200) above the first and the second electrical connections,
removing the substrate so as to expose the metal barrier layer,
patterning the metal barrier layer so as to electrically disconnect from each other the first anodizable metal region, the bottom electrode layer of the first capacitor, the second anodizable metal region, and the bottom electrode of the second capacitor.

2. The method of claim 1, wherein removing the substrate comprises grinding at least a portion of the substrate.

3. The method of claim 2, wherein the substrate comprises a layer of insulating material (202) in contact with the metal barrier layer, and removing the substrate comprising grinding the substrate until the layer of insulating material is reached, and removing the layer of insulating material by etching.

4. The method of any one of claims 1 to 3, comprising, after patterning the metal barrier layer, forming a passivation layer (130) including a plurality of openings that respectively open onto the first anodizable metal region, a remaining portion (103A) of anodization barrier layer under the bottom electrode layer of the first capacitor, the second anodizable metal region, and a remaining portion (103B) of anodization barrier layer under the bottom electrode of the second capacitor.

5. The method of claim 4, comprising forming a conductive contact pad (131A, 132A, 131B, 132B) inside each opening.

6. The method of any one of claims 1 to 5, comprising, prior to bonding the support, depositing a planarization layer (125) above the first and the second electrical connections, and planarizing the planarization layer,
wherein the support is bonded to the planarized planarization layer.

7. The method of any one of claims 1 to 5, wherein the support comprises an electrical component (210) and bonding the support comprises performing a hybrid bonding.

8. The method of any one of claims 1 to 7, comprising forming a separating porous region (105C) that separates the first anodizable metal region from the second anodizable metal region.

9. An integrated device comprising a first capacitor and a second capacitor, comprising:
a patterned metal layer (103A, 103B),
on the patterned metal layer, a layer including a first anodic porous oxide region (105A) surrounded by a first anodizable metal region (106A) and a second anodic porous oxide region (105B) surrounded by a second anodizable metal region (106B), the first and the second anodic porous oxide regions each comprising a plurality of substantially straight pores that extend from a top surface of the anodic porous oxide region towards the metal barrier layer,
a first stacked capacitive structure (110A) arranged inside the pores of the first anodic porous oxide region, the first stacked capacitive structure comprising a bottom electrode layer (111) in electrical contact with the metal barrier layer at the bottom of the pores, a top electrode layer (113), and a dielectric layer (112) arranged between the bottom and the top electrode layer, forming the first capacitor,
a second stacked capacitive structure (110B) arranged inside the pores of the second anodic porous oxide region, the second stacked capacitive structure comprising a bottom electrode layer (111) in electrical contact with the metal barrier layer at the bottom of the pores, a top electrode layer (113), and a dielectric layer (112) arranged between the bottom and the top electrode layer, forming the second capacitor,
above the first capacitor, a first electrical connection (124A) between the top electrode layer of the first capacitor and the first anodizable metal region,
above the second capacitor, a second electrical connection (124B) between the top electrode layer of the second capacitor and the second anodizable metal region,
a support (200) bonded above the first and the second electrical connections,
wherein the metal barrier is patterned so as to electrically disconnect from each other the first surrounding region, the bottom electrode layer of the first capacitor, the second surrounding region, and the bottom electrode of the second capacitor.

10. The device of claim 9, comprising a passivation layer (130) including a plurality of openings that respectively open onto the first surrounding region, a remaining portion of anodization barrier layer under the bottom electrode layer of the first capacitor, the second surrounding region, and a remaining portion of anodization barrier layer under the bottom electrode of the second capacitor.

11. The device of claim 9 or 10, comprising a conductive contact pad (131A, 132A, 131B, 132B) inside each opening.

12. The device of any one of claims 9 to 11, comprising a planarization layer (125) above the first and second electrical connections, having a planarized surface, the support being bonded to the planarized surface of the planarization layer.

13. The device of any one of claims 9 to 11, wherein the support comprises electrical components and the support is bonded by hybrid bonding.

14. The device of any one of claims 9 to 13, comprising a separating porous region that separates the first anodizable metal region from the second anodizable metal region.
